# EUROPÄISCHE PATENTSCHRIFT

(11) **EP 2 703 525 B1**
(45) Veröffentlichungstag und Bekanntmachung des Hinweises auf die Patenterteilung: **10.12.2014**
(21) Anmeldenummer: 13179560.1
(22) Anmeldetag: 07.08.2013
(51) Int. Cl.: C30B 13/08, C30B 13/20, C30B 29/06, C30B 13/10

(54) **Verfahren zum Herstellen eines Einkristalls aus Silizium**
Method for producing a silicon single crystal
Procédé destiné à la fabrication d'un monocristal de silicium

(30) Priorität: 04.09.2012 DE 102012215677
(43) Veröffentlichungstag der Anmeldung: 05.03.2014
(73) Patentinhaber: Siltronic AG, 81737 München (DE)
(72) Erfinder: Lobmeyer, Josef, 94072 Bad Füssing (DE); Brenninger, Georg, 84564 Oberbergkirchen (DE); Stein, Waldemar, 84489 Burghausen (DE)
(74) Vertreter: Staudacher, Wolfgang

(56) Entgegenhaltungen:
- DE-A1- 4 416 543
- DE-A1-102009 051 010

## Beschreibung

Gegenstand der Erfindung ist ein Verfahren zum Herstellen eines Einkristalls aus Silizium, umfassend die folgenden Schritte: das induktive Erhitzen einer Platte aus Silizium; das Schmelzen von körnigem Silizium auf der Platte aus Silizium; und das Zuführen des geschmolzenen Siliziums durch ein Ablaufrohr im Zentrum der Platte zu einer Phasengrenze, an der ein Einkristall aus Silizium kristallisiert.

Ein solches Verfahren, das nachfolgend kurz GFZ-Verfahren genannt wird, ist beispielsweise in der DE 10 2009 051 010 A1 beschrieben. Es ist eine Abwandlung des Zonenziehens ("floating zone method", FZ-Verfahren), zu dem einige besondere Unterschiede bestehen. Das Material, das beim GFZ-Verfahren geschmolzen und zu einem Einkristall aus Silizium kristallisiert wird, ist körniges polykristallines Silizium ("granular polycrystalline silicon"), sogenanntes Granulat, während beim FZ-Verfahren ein Vorratsstab ("feed rod") aus polykristallinem Silizium verwendet wird. Zum Schmelzen des körnigen Siliziums und zur Regelung der Kristallisation des Einkristalls werden jeweils eigene Induktionsheizspulen eingesetzt, während beim FZ-Verfahren für beide Aufgaben eine gemeinsame Induktionsheizspule vorgesehen ist. Nur beim GFZ-Verfahren gebräuchlich ist eine Platte, auf der Granulat geschmolzen und in geschmolzenem Zustand durch ein Ablaufrohr im Zentrum der Platte der Phasengrenze zugeführt wird, an der der Einkristall aus Silizium kristallisiert.

In einer Anfangsphase des GFZ-Verfahrens wird das noch verschlossene Ablaufrohr von unten teilweise geschmolzen, so dass sich ein kleines Volumen geschmolzenen Siliziums, ein Schmelzentropfen, bildet. Die zum Schmelzen des verschlossenen Ablaufrohrs erforderliche Energie wird induktiv von der unter der Platte angeordneten Induktionsheizspule, der Ziehspule, übertragen. An den Schmelzentropfen wird von unten ein Keimkristall angesetzt und wieder abgesenkt. An der Phasengrenze, die beim Kontakt des Keimkristalls mit dem Schmelzentropfen entstanden ist, kristallisiert nach einer Phase der Beseitigung von Versetzungen ein Einkristall aus Silizium. Das zum Wachsen des Einkristalls benötigte Silizium wird zunächst noch durch Schmelzen des Verschlusses des Ablaufrohrs bereitgestellt, später im Wesentlichen durch Schmelzen von Granulat auf der Platte und durch Zuführen der entstandenen Schmelze durch das nun offene Ablaufrohr zur Phasengrenze. Die zum Schmelzen des Granulats erforderliche Energie wird induktiv von der über der Platte angeordneten Induktionsheizspule, der Aufschmelzspule, auf die Platte und auf darauf liegendes Granulat übertragen.

Silizium ist ein Halbleiter, der bei Raumtemperatur elektrischen Strom kaum leitet. Dementsprechend ist induktives Erhitzen von Silizium erst bei vergleichsweise hohen Temperaturen wirksam. In der DE 44 16 543 A1 wird im Zusammenhang mit dem FZ-Verfahren vorgeschlagen, die induktive Kopplung von Silizium mit einer Induktionsheizspule zu erleichtern, indem Silizium mittels eines Suszeptors auf Temperaturen vorgeheizt wird, bei denen die elektrische Leitfähigkeit von Silizium deutlich höher ist als bei Raumtemperatur.

Der Einsatz eines solchen Suszeptors kommt für das GFZ-Verfahren nicht in Frage, weil seine Anwesenheit beim Kristallisieren des Einkristalls stören würde.

Die elektrische Leitfähigkeit von Silizium bei Raumtemperatur lässt sich durch Dotieren des Siliziums mit einem elektrisch aktiven Dotierstoff vom p-Typ oder n-Typ erhöhen. Beispiele für geeignete Dotierstoffe sind insbesondere Bor (p-Typ) und Phosphor (n-Typ).

Die Platte kann daher bereits bei Raumtemperatur induktiv erhitzt werden, sofern sie eine entsprechend hohe Konzentration an Dotierstoff aufweist.

Nachteilig daran ist, dass in der Platte enthaltener Dotierstoff während des Wachsens des Einkristalls unkontrolliert von der Platte in den Einkristall gelangen kann. Üblicherweise wird jedoch verlangt, dass der Einkristall und die daraus hergestellten Halbleiterscheiben Dotierstoff-Konzentrationen aufweisen, die einer vorbestimmten Spezifikation genügen und nicht durch unkontrollierte Einflüsse verfälscht sind.

Aufgabe der Erfindung ist es daher, ein GFZ-Verfahren aufzuzeigen, das solche Nachteile vermeidet.

Gegenstand der Erfindung ist ein Verfahren zum Herstellen eines Einkristalls aus Silizium, umfassend
das induktive Erhitzen einer Platte aus Silizium;
das Schmelzen von körnigem Silizium auf der Platte aus Silizium; und
das Zuführen des geschmolzenen Siliziums durch ein Ablaufrohr im Zentrum der Platte zu einer Phasengrenze, an der ein Einkristall aus Silizium kristallisiert, gekennzeichnet durch das induktive Erhitzen eines Rings aus Silizium vor dem induktiven Erhitzen der Platte, wobei der Ring auf der Platte liegt und einen kleineren spezifischen Widerstand als die Platte hat; und
das Schmelzen des Rings.

Der elektrisch leitfähige Ring kann bereits bei Raumtemperatur mit der Induktionsheizspule koppeln. Ein Teil der im Ring entstehenden Wärme wird über Wärmeleitung auf die Platte übertragen, so dass diese bald die Temperatur zum effektiven Koppeln mit der Induktionsheizspule erreicht. Der Ring wird schließlich vollständig geschmolzen und in geschmolzenem Zustand mit dem darin enthaltenen Dotierstoff durch das Ablaufrohr dem wachsenden Einkristall zugeführt, und schließlich als vergleichsweise kleiner Bestandteil des Einkristalls kristallisiert. Die im Ring enthaltenen Dotierstoffe sind damit gebunden und können nicht in den Hauptteil des Einkristalls gelangen, der in der Folge durch Schmelzen von Granulat und Kristallisieren des geschmolzenen Granulats an der Phasengrenze gebildet wird.

Die Platte enthält keine elektrisch aktiven Dotierstoffe oder ist vergleichsweise gering dotiert. Der spezifische Widerstand des Rings ist vorzugsweise um nicht weniger als 90 % kleiner als der spezifische Widerstand der Platte. Besonders bevorzugt ist ein spezifischer Widerstand des Rings von nicht mehr als 80 mΩcm, und ein spezifischer Widerstand der Platte von nicht weniger als 1 Ωcm.

Der Ring ist kleiner dimensioniert als die Platte. Die Länge des Außendurchmessers des Rings ist vorzugsweise um nicht weniger als 40 % kleiner als die Länge des Außendurchmessers der Platte. Die Länge des Innendurchmessers des Rings entspricht vorzugsweise der Länge des Innendurchmessers des Ablaufrohrs der Platte. Die Dicke des Rings ist vorzugsweise um nicht weniger als 80 % kleiner als die Dicke der Platte.

Der Ring wird vorzugsweise aus einem Einkristall geschnitten, der nach dem GFZ-Verfahren oder dem FZ-Verfahren hergestellt worden ist. Die Platte wird ebenfalls vorzugsweise aus einem Einkristall geschnitten, der nach dem GFZ-Verfahren oder FZ-Verfahren hergestellt worden ist.

Die Erfindung wird nachfolgend mit Bezugnahme auf eine Zeichnung beschrieben.

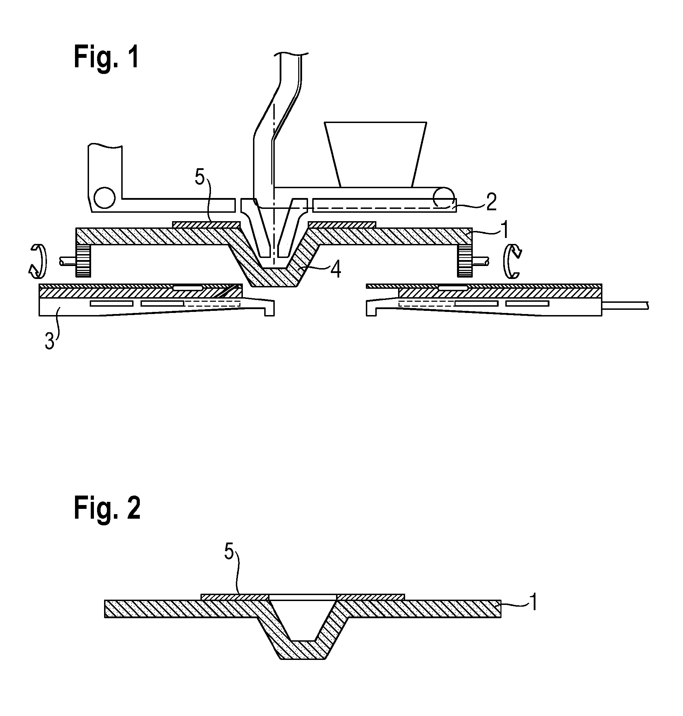

Fig.1 zeigt eine Anordnung von Vorrichtungsmerkmalen, die zur Durchführung des erfindungsgemäßen Verfahrens geeignet sind.

Zusätzlich zu Bekanntem aus beispielsweise der DE 10 2009 051 010 A1 ist ein Ring 5 dargestellt, der auf einer Platte 1 abgelegt ist, und mit Hilfe einer oberen Induktionsheizspule 2, die über der Platte 1 angeordnet ist, induktiv erhitzt wird. Dargestellt ist ein Zeitpunkt, der vor dem Erzeugen eines Schmelzentropfens am unteren Ende eines Ablaufrohrs 4 der Platte 1 mit Hilfe einer unteren Induktionsheizspule 3 liegt.

### Beispiel und Vergleichsbeispiel:

Unter Verwendung einer Vorrichtung mit den in Fig.1 gezeigten Merkmalen wurde ein Einkristall aus Silizium erfindungsgemäß hergestellt.

Auf der Platte aus Silizium mit einem Außendurchmesser von 150 mm und einer Dicke von 7 mm wurde ein Ring aus Silizium gelegt. Der Außendurchmesser des Rings war 75 mm, der Innendurchmesser 35 mm und die Dicke des Rings betrug 0,7 mm. Der Ring war mit elektrisch aktivem Dotierstoff dotiert und hatte einen spezifischen Widerstand von 20 mΩcm. Der spezifische Widerstand der Platte war 60 Ωcm.

Zunächst wurde der hochdotierte Ring mit Hilfe der oberen Induktionsheizspule erhitzt, und Wärme vom erhitzten Ring auf die darunterliegende Platte übertragen. Nachdem die Platte eine Temperatur von ungefähr 600 °C erreicht hatte, konnte die Platte direkt innerhalb von einigen Minuten auf eine Temperatur im Bereich der Schmelztemperatur von Silizium induktiv erhitzt werden und das GFZ-Verfahren durchgeführt werden.

Zum Vergleich wurde das GFZ-Verfahren ohne Ring, aber mit einer hochdotierten Platte durchgeführt, deren spezifischer Widerstand 30 mΩcm war.

Eine Untersuchung des axialen Verlaufs des spezifischen Widerstands der hergestellten Einkristalle ergab einen deutlich homogeneren und näher am spezifizierten Widerstand liegenden Verlauf bei dem Einkristall, der erfindungsgemäß hergestellt worden war.

## Patentansprüche

1. Verfahren zum Herstellen eines Einkristalls aus Silizium, umfassend
das induktive Erhitzen einer Platte aus Silizium;
das Schmelzen von körnigem Silizium auf der Platte aus Silizium; und
das Zuführen des geschmolzenen Siliziums durch ein Ablaufrohr im Zentrum der Platte zu einer Phasengrenze, an der ein Einkristall aus Silizium kristallisiert, **gekennzeichnet durch** das induktive Erhitzen eines Rings aus Silizium vor dem induktiven Erhitzen der Platte, wobei der Ring auf der Platte liegt und einen kleineren spezifischen Widerstand als die Platte hat; und
das Schmelzen des Rings.

2. Verfahren nach Anspruch 1, **dadurch gekennzeichnet, dass** der Ring einen spezifischen Widerstand von nicht mehr als 80 mΩcm aufweist.

3. Verfahren nach Anspruch 1 oder Anspruch 2, **dadurch gekennzeichnet, dass** die Platte einen spezifischen Widerstand von nicht weniger als 1 Ωcm aufweist.

4. Verfahren nach einem der Ansprüche 1 bis 3, **dadurch gekennzeichnet, dass** der Außendurchmesser des Rings kleiner ist als der Außendurchmesser der Platte.

5. Verfahren nach einem der Ansprüche 1 bis 4, **dadurch gekennzeichnet, dass** der Innendurchmesser des Rings mit dem Innendurchmesser des Ablaufrohrs übereinstimmt.

6. Verfahren nach einem der Ansprüche 1 bis 5, **dadurch gekennzeichnet, dass** die Dicke des Rings kleiner als die Dicke der Platte ist.

## Claims

1. Method for producing a silicon single crystal, comprising
inductive heating of a silicon plate;
melting granular silicon on the silicon plate; and delivery of the molten silicon through a flow conduit in the center of the plate to a phase boundary, at which a silicon single crystal crystallizes, **characterized by**
inductive heating of a silicon ring before the inductive heating of the plate, the ring lying on the plate and having a lower resistivity than the plate; and
melting the ring.

2. Method according to Claim 1, **characterized in that** the ring has a resistivity of not more than 80 mΩcm.

3. Method according to Claim 1 or 2, **characterized in that** the plate has a resistivity of not less than 1 Ωcm.

4. Method according to one of Claims 1 to 3, **characterized in that** the outer diameter of the ring is less than the outer diameter of the plate.

5. Method according to one of Claims 1 to 4, **characterized in that** the inner diameter of the ring is the same as the inner diameter of the flow conduit.

6. Method according to one of Claims 1 to 5, **characterized in that** the thickness of the ring is less than the thickness of the plate.

## Revendications

1. Procédé pour la fabrication d'un monocristal de silicium, comprenant
le chauffage par induction d'une plaque de silicium ;
la fusion de silicium granulaire sur la plaque de silicium ; et
l'introduction du silicium fondu par un tube d'écoulement au centre de la plaque en une limite de phase, au niveau de laquelle cristallise un monocristal de silicium, **caractérisé par** le chauffage par induction d'un anneau de silicium avant le chauffage par induction de la plaque, l'anneau reposant sur la plaque et ayant une plus faible résistance spécifique que la plaque ; et
la fusion de l'anneau.

2. Procédé selon la revendication 1, **caractérisé en ce que** l'anneau présente une résistance spécifique n'excédant pas 80 mΩcm.

3. Procédé selon la revendication 1 ou la revendication 2, **caractérisé en ce que** la plaque présente une résistance spécifique d'au moins 1 Ωcm.

4. Procédé selon l'une quelconque des revendications 1 à 3, **caractérisé en ce que** le diamètre externe de l'anneau est inférieur au diamètre externe de la plaque.

5. Procédé selon l'une quelconque des revendications 1 à 4, **caractérisé en ce que** le diamètre interne de l'anneau correspond au diamètre interne du tube d'écoulement.

6. Procédé selon l'une quelconque des revendications 1 à 5, **caractérisé en ce que** l'épaisseur de l'anneau est inférieure à l'épaisseur de la plaque.
